Europäisches Patentamt

European Patent Office

Office européen des brevets

(19)

(11) Publication number: **0 466 999 A1**

# EUROPEAN PATENT APPLICATION

(12)

(21) Application number: **90810548.9**

(22) Date of filing: **18.07.90**

(51) Int. Cl.⁵: **C23C 14/54**, C23C 14/56

---

The title of the invention has been amended (Guidelines for Examination in the EPO, A-III, 7.3).

(43) Date of publication of application:
**22.01.92 Bulletin 92/04**

(84) Designated Contracting States:
**AT BE CH DE DK ES FR GB GR IT LI LU NL SE**

(71) Applicant: **ENGINEERING FILMS-ESTABLISHMENT**

Aeulestrasse 80
Vaduz(LI)

(72) Inventor: **Mosca Tenna, Giovanni**
**Elektrastrasse 38**
**W -8000 München 81(DE)**

(74) Representative: **Moretti, Francesco, Dr.**
**e/o ENGIMPEX S.A., Industrial Property Serv.**
**Dept., Via Ponte Tresa 7b, P.O. Box 12**
**CH-6924 Sorengo(CH)**

---

(54) **Process and apparatus for the surfacing of tape substrates of reels.**

(57) The characteristic phases of the process are carried out separately into different and seoparate chambers or modules (I, II, III) of chambers (polychambers), one for each single distinstive phase of the process.

The layout with separate execution of the phases of the process into different chambers with subdivision of the transfers of material in different chambers (unlike the devices of the known monochamber technique) increases the quality and reliability of the end item, because the passing of impurities from a module to another one is prevented so that the different phases of unwinding/rewinding take place in perfect cleanliness.

The differentiation in different chambers besides contributing to more cleanliness and to an easier maintenance and control of the operation with reduced costs, induces also a remarkable energy saving and higher reliability, because the different modules can work with differentiated pressures.

Fig. 1

EP 0 466 999 A1

This invention refers to a process for surfacing of metallic and/or insulating materials on tape supports on reels to be used in the industry of electrics/electronics, packing, fabrics, decorative and wall papers, labelling and hot-stamping.

Each different phase of the process takes place in a separate underpressurized compartment, allowing to reach a high quality and reliability of the end item together with homogeneity of the deposition layer of the surfacing material, remarkable cleanliness in the different phases of the process as well as important advantages as far as the control of the operation and maintenance is concerned.

More precisely this invention refers to a process for the surfacing of metallic and/or insulating materials on tape supports on reels, to the apparatus for its execution and to the products obtained in this way, particularly for electric and electronic appliances, packing, fabrics, decorative and wall papers, labelling and hot-stamping, where each distinctive phase of the process takes place separately in one or more coupled chambers, which make up modules.

The separate location of the distinctive phases of the process in different chambers, particularly splitting up the possible different coatings and the unwinding and rewinding of the tape support in different chambers, induces a remarkable increase in the quality of the end item as well as a perfect cleanliness of the same and of the unwinding/rewinding gears with obvious advantages in the operation and maintenance.

All the processes of the known technique provide a single vacuum chamber, which includes two or more chambers inside, where the process takes place with the phases of unwinding, evaporation, metallization and lubrication (with or without screens), rewinding in a single underpressurized environment.

The innovation of the process consists in the execution of its different constitutive phases in at least three separate modules, one for each main phase, each composed of one vacuum chamber (monochamber) or of many vacuum chambers (polychamber).

In the first vacuum module the unwinding of the reels of the tape support or film of plastic material to be covered or respectively metallized takes place.

The tape support can be papery or textile or synthetic.

The plastic film can be a pressing, a coextrusion, a laquered, a coated (by wax or other materials).

The unwound tape runs along a vacuum tunnel which brings it in the

Second vacuum module, where the coating by the surfacing material or the single real metallization or the different coatings and metallizations subsequently in different chambers take place.

The supporting rollers of the film are cooled and the presence of screens or of an oil-feeder for the lubrication allows the desidered screening of the parts of tape or film not to be metallized.

After the coating(s) or metallization(s) the tape support or film runs a long a vacuum tunnel to pass in a

Third vacuum module, where the rewinding of the coated or metallized tape or film on its reel takes place.

More precisely this invention refers to a process for the surfacing of metallic and/or insulating materials on tape supports on reels, to be used in the industry of electrics/electronics, packing, fabrics, decorative and wall papers, labelling and hot-stamping, characterized by the fact that the different phases of the process, unwinding of said support, coating, rewinding of said support, take place separately, each one in at least one vacuum module.

The process for the surfacing of metallic and/or insulating materials on tape supports on reels, which is the subject of the invention, includes the following phases in one of its peculiar ways of execution:

a) in a first module (at least one), constituted by a vacuum chamber, the reels of the tape support are unwound;

b) in a second module (at least one), also constituted by a vacuum chamber connected to the previous one through a connecting vacuum tunnel, the real surfacing of the coating material on the tape support is carried out, after stretching and lenghtening, with a subsequent lubrication, if required;

c) in a third module (at least one), constituted by a vacuum chamber connected to the previous one through a vacuum tunnel, the rewinding of the support takes place, after srtetching and lenghtening.

Each one of the said phases takes place in at least one modular vacuum chamber, where each single distinctive phase of the process takes place.

This invention has also the aim to propose an apparatus for the execution of the process for the surfacing of metallic and/or insulating materials on tape support on reels, which is characterized by including:

i) at least one first module, constituted by at least one vacuum chamber, for unwinding of the reel of the tape support to be coated, with means of easy access to load and unload the roller carrying the reel;

ii) at least one second module, constituted by at least one vacuum chamber, with a tape stretcher, a winding roller, possibly an oil-feeder for the screening of the parts not to be coated, means for melting and evaporating the surfacing materials, a lubricator, tape tensioning devices;

iii) at least one third module, constituted by at least one vacuum chamber, for the rewinding of the fully or partially coated support, provided with stretching rollers, roller for the rewinding of the support, means of access and unloading of the reel;

iv) connecting tunnel between the vacuum modules for transferring the tape support from a module to the next one.

Moreover this invention refers to the coated products obtained by the process and the apparatus of the invention, like metallized plastic films, decorative or wall papers, fabrics wth surfacing materials, labels, prints and so on, particularly for use respectively as dielectric, for wrapping or packaging, for furniture and dressing, for labelling, publishing, typography and printing.

Particular ways of carrying out the process of the invention provide that each one of the distinctive phases of the process can be executed many times in parallel in modular polychambers.

In the same way every coating or metallization can take place in a separate chamber or module for each metallic or insulating material.

To avoid the coating, respectively the metallization, of the part of tape or film which is required to be left free, the use of suitable screening is provided, particularly by means of lubrication through oil-feeder. The process of the invention well adapts itself to pressed, coextruded, laquered, coated (by wax or other materials) or coupled films, as well as to decorative and wall papers, printing papers and labels, fabrics.

In a preferred way of execution of the apparatus carrying out this process, also subject of the invention, a differentiated degree of vacuum is produced in each module and in the tunnels which connect the modules, according to the requirements of the different phases of the process, allowing to save energy and money.

In this connection independent cryogenic groups are provided for each module.

Moreover the chambers of the coating modules, particularly metallization modules, provide the possibility to extract means (inductive high frequency crucibles, electronic guns) of melting/evaporating of metals or insulators through lateral dorrs from the chambers; their easy and quick replacement increases the production rate besides assuring more cleanliness and better quality of the end items.

The machinery of the apparatus or plant, which carries out the phases of coating(s)/ metallization(s) and rewinding of the plastic film, is provided with means measuring and surveying the regularity of the deposit of material (superficial density) and the uniformity of thickness of the surfacing layer of material of metal deposited along the running length of the film.

A first electric instrument connected with the chambers of the metallization module measures the average chemical resistance of the metallized surface along the reel. A second one placed in the chambers of the rewinding module measures the absorption value of the light (optical density) or radiation emitted by a light or infrared projector, in the position corresponding to each mean (crucible and so on) to give a reading of the thickness of material deposed by evaporation by each mean, crucible, high frequency inductor or electronic gun, giving at the same time as indication of a correct operation of the mean itself.

The access to the chambers of the unwinding and rewinding rollers occurs through coulisse coors and the loading and unloading of the reels by means of a convenient swinging-arm system.

To optimize the apparatus, the connecting tunnels between the modules for the running of the tape have a differentiated degree of vacuum, being provided at the beginning and at the end of each section with slots of variable width, which even allowing the passing of the tape avoid the losses of vacuum and the passing of impurities.

Now we give a detailed but not limiting description of the subject of this invention in the following, according to a preferred way of execution, with reference to the attached drawings, without taking anything from the generality of the invention itself:

- the figure 1 shows a front view of the apparatus executing the process of the invention;
- the figure 2 shows a front view of the module I;
- the figure 3 shows a front view of the module II;
- the figure 4 shows a front view of the module III;
- the figure 5 shows a plan view of the apparatus executing the process of the invention;
- the figure 6 represents a not limiting polychamber modular arrangement of the modules which carry out the distinctive phases of the process of the invention.

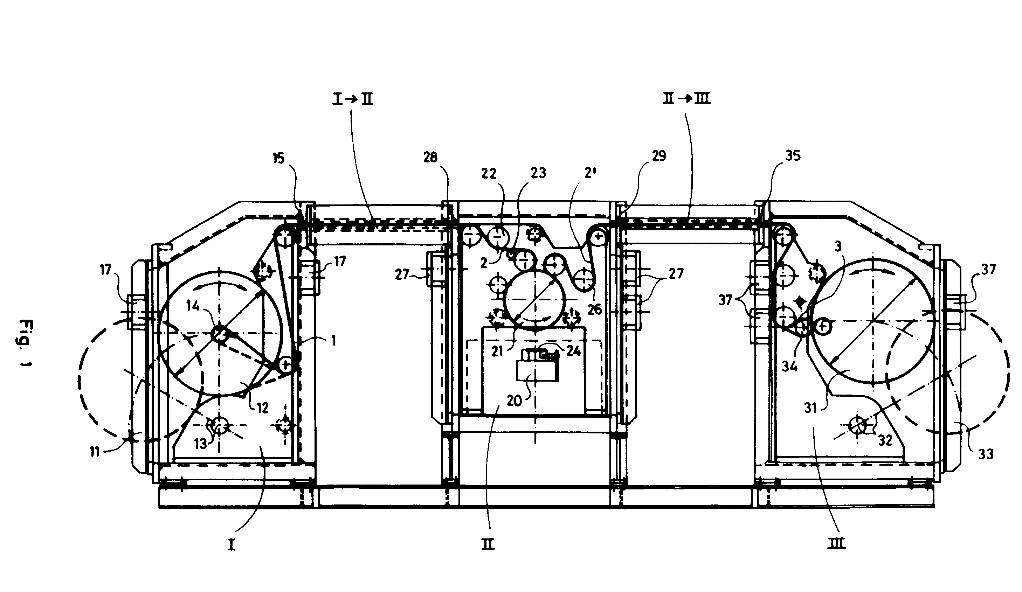

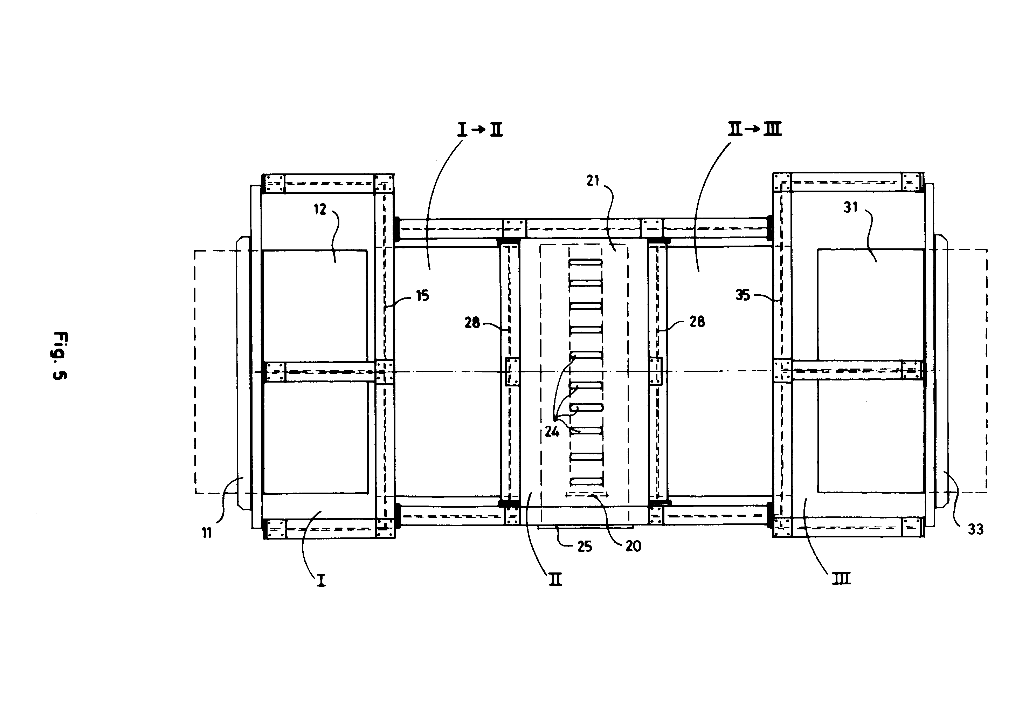

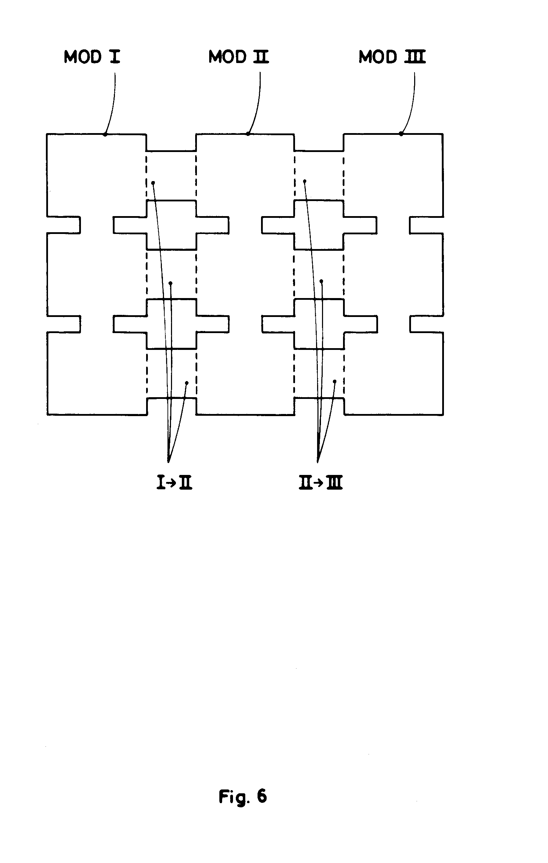

The apparatus of the process includes at least three monochamber (figures 1 and 5) or polychamber (figure 6) modules I, II, III.

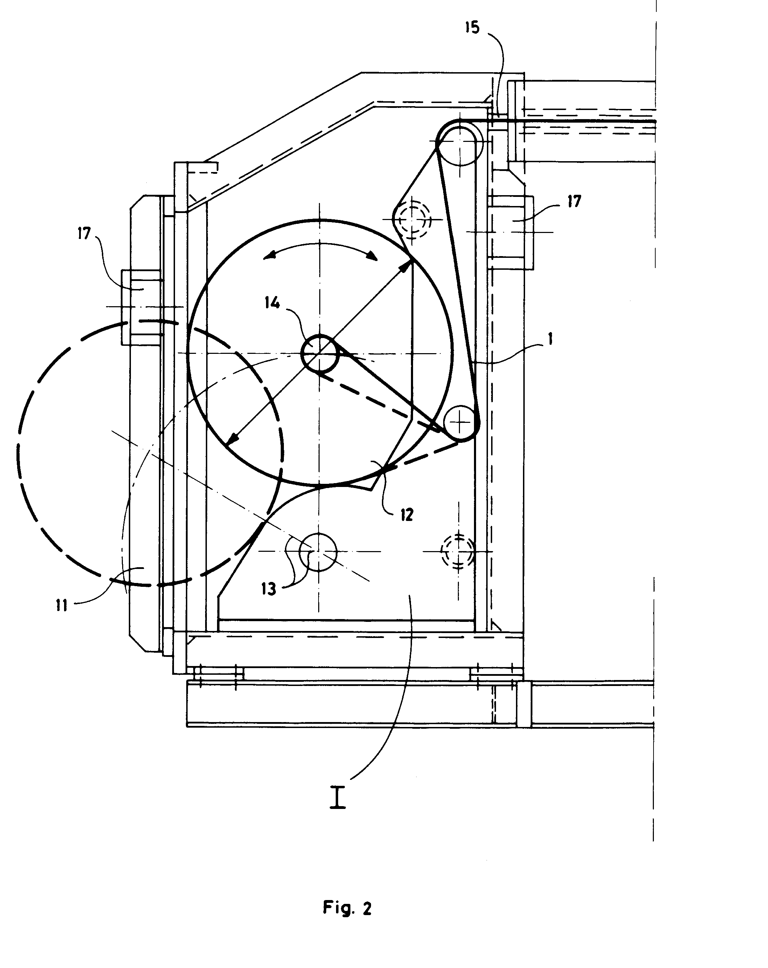

The module I (figures 1, 2 and 5) is constituted by a vacuum chamber provided with a coulisse door 11 which includes the reel 12 for the unwinding of the tape or plastic film 1 to be coated or metallized mounted on swinging arms 13.

The reel is inserted through a front opening with a door sliding on horizontal rails (coulisse door). The reel is mounted on swinging arms which take the reel outside and put it into the chamber inserting it between the unwinding pins 14.

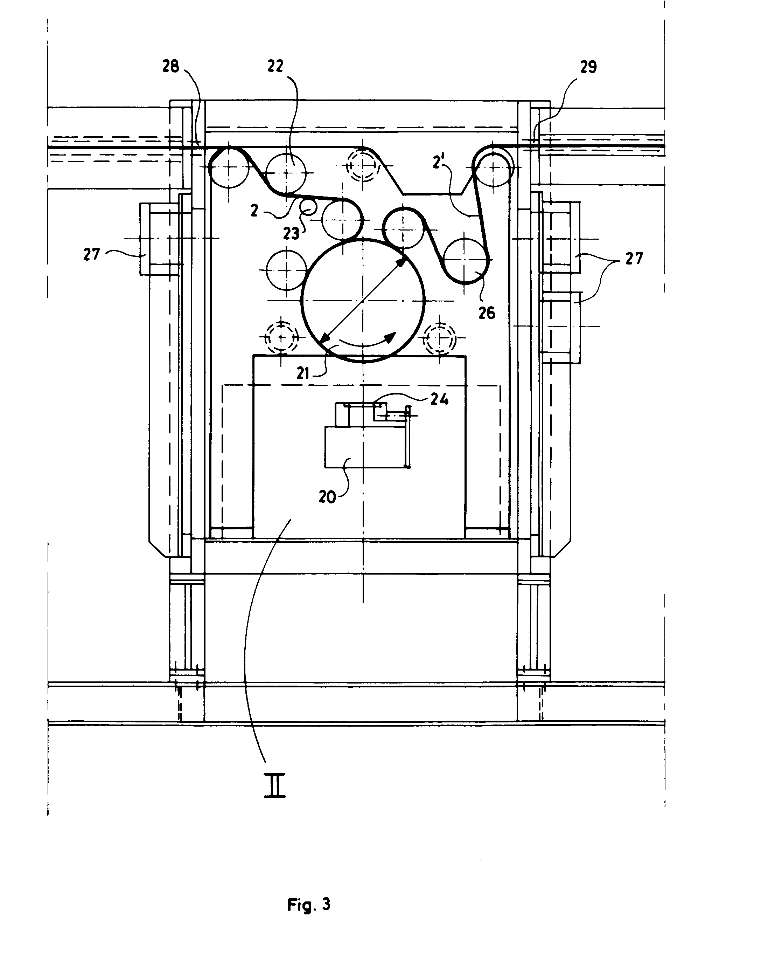

The module II (figures 1, 3 and 5) carries out the real coating(s) or metallization(s) and is constituted by a vacuum chamber provided with port holes 27 (also present in the modules I and II, 17 and 37), where there is a roller 21 cooled by a suitable system which drives the tape or plastic film 2 to be coated or metallized, previously stretched by the stretcher 22 and possibly lubricated by the oil-feeder 23 in the parts of tape/film which are required without coating/metallization.

The evaporating means of the surfacing materials 24 are extractable 20 crosswise through a suitable door 25 and interchangeable.

The tape stretcher or friction roller 26 provides to suitable stretch the coated/metallized film 2'.

In the second chamber or central module the cylinder 21 with a diameter of 500 mm is cooled down to a temperature variable between + 40 $^\circ$C and - 25 $^\circ$C. In the lower part there is the evaporator of the metallic/insulating material constituted by a range of means like crucibles, high frequency inductors, electronic guns, whose number depends on the width of the reel: one means approx. every 10 cm of tape width plus one.

The furnace and the mean-holder 20 are extractable and interchangeable according to the type of metrial to be avaporated. The melting/evaporating crucibles are used in the case of metals (particularly aluminum); or an electronic gun for the evaporation of metallic oxides and other types of metals is used; or high frequency inductors are used.

By these means it is possible to evaporate a large range of materials. like mica, silicon, "teflon", aluminum, metalloids, alloys, semiconductors, particularly quartz, oxides, sub-oxides, nitrites, fluorates, sulphates and so on. Also tape.stretching rollers and screening rollers with oil-feeder to cover and preserve determined zones from the coating/metallization are arranged; as last a traction roller.

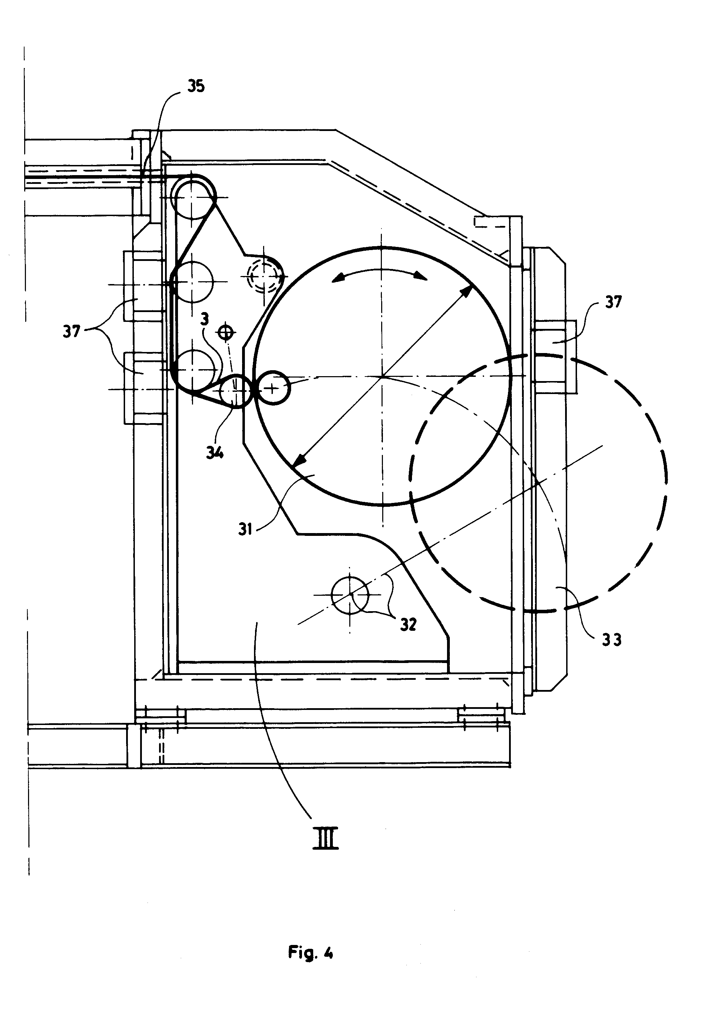

The module III (figures 1, 4 and 5) of rewinding of the coated tape or metallized film 3 is also consituted by a vacuum chamber closed by a coulisse door 33 into which the rewinding reel 31 mounted on swinging arms 32 is placed and by the stretching and return roller 34 for the previous and correct stretching and tensioning of the tape/film before the final rewinding.

The rollers for the different modules are all powered by DC motors.

Each module is pressurized by a different vacuum pump group according to the differentiated pressure required by the different phases of the production cycle.

In particular cryogenic groups are used in the modules I and II to increase the efficency of the vacuum system.

Moreover a double control system (not shown in the figures) of the uniformity of deposition of the metal is provided:

one of traditional type for the module II controlling the average ohmic value of the metallized surface of the reel, one for the module III controlling light transmission, absorption, optical density and formed by a projector (light or infrared) and a receiver in connection to each evaporating mean, which provides beside the reading of the thickness of the deposed layer of metal also the index of the correct operation of said mean/evaporator.

CONNECTING TUNNELS (figures 1 and 6).

The tape support runs in connecting vacuum tunnels I-II, which connect the chambers of the different modules.

The connecting vacuum tunnels which connect a module to the next one have a width of approx. 50 mm in the zone where the tape support runs and adjustable thin plates (throats to obtain differentiated vacuum) 15,28,29,35 are placed at the end of each part of the tunnel in order to reduce the width to the minimum thickness of passage of the rope.

The pressure is approx. 2 x 10exp-4 torr in the module II, while in the modules I and III a pressure of approx. 10exp-3 torr is enough.

This disposition eliminate the passage of impurities between the chambers of the different modules.

**Claims**

1. Process for the surfacing of metallic and/or insultating materials on tape supports on reels to be used in the industry of electrics/electronics, packing, fabrics, decorative and wall papers, labelling and hot-stamping, characterized by the fact that the different phases of the process, unwonding of said support, coating, rewinding of said support, take place separately, each one into at least one vacuum module.

2. Process for the surfacing of metallic and/or insulating materials on tape supports on reels according to the Claim 1, characterized by the fact that it includes the following phases:

a) in at least one first module, constituted by a vacuum chamber, the reels of the tape support are unwound;

b) in at least one second module, also consituted by a vacuum chamber connected to the previous one through a connecting vacuum tunnel, the real surfacing of the coating material on the tape support is performed after stretching, tensioning and subsequent lubricating (if required) of the tape support;

c) in at least one third module, constituted by a vacuum chamber connected to the previous one through a connecting vacuum tunnel, the rewinding of the support is performed after stretching and tensioning;

each one of these phases take place in at least one modular vacuum chamber where each single distinctive phase of the process takes place.

3. Process for the surfacing of metallic and/or insulating materials on tape supports on reels according to the Claim 2, where each one of the single distinctive phases (a), (b) and (c) is performed into vacuum modular polychambers connected through vacuum tunnels where the support runs.

4. Process for the surfacing of metallic and/or insulating materials on tape supports on reels according to the Claim 3, where each single surfacing of material according to the phase (b) of said process takes place into a chamber or module separately for each material.

5. Process for the surfacing of metallic and/or insulating materials on tape supports on reels according to any one of the claims 1 to 4, where the surfacing of material on the support is only partially performed, after screening of the part not to be coated, possibly by lubrication.

6. Process for the surfacing of metallic and/or insulating materials according to any one of the Claims 1 to 5, where the support is a pressed or coextruded or laquered or coated (by wax or any other material) or coupled plastic film and the surfacing material is a metal.

7. Process according to any one of the Claims 1 to 5, where the surfacing materials are oxides or "teflon" or mica or silicon or other materials like aluminum, metalloids, alloys, semi conductors, particularly quartz, sub-oxides, nitrites, fluorates, sulphates and so on.

8. Apparatus for the execution of the process for the surfacing of metallic and/or insulating materials on tape supports on reels according to any one of the Claims 1 to 7, characterized by the fact that it includes:

i) at least one first module constituted by at least one vacuum chamber for the unwinding of the reel of the tape support to be coated, with means of easy access to load and unload the roller carrying the reel;

ii) at least one second module constituted by at least one vacuum chamber, with a tape stretcher, a winding roller, possibly an oil-feeder for the screening of the parts not to be coated, means for melting and evaporating the surfacing materials, a lubricator, tape tensioning devices;

iii) at least one third module constituted by at least one vacuum chamber for rewinding the fully or partially coated support, provided with stretching rollers, roller for rewinding the support, means of access and of unloading of the reel;

iv) connecting tunnel between the vacuum modules to transfer the tape support from a module to the next one.

9. Apparatus for the surfacing of metallic and/or insulating materials on tape supports on reels according to the Claim 8, characterized by the fact that the pressures in each monochamber or polychamber module and in the sections of the connecting tunnel are differentiated and can be kept at different values according to the requirements of the process.

10. Apparatus for the surfacing of metallic and/or insulating materials on tape supports on reels according to the Claim 8 or 9, characterized by the fact that the chambers of the coating module provide means for supplying the surfacing materials like oxides, mica, "teflon", silicon and other materials like aluminum, metaloids, alloys, semiconductors, particularly quartz, sub-oxides, nitrites, fluorates, sulphates and so on, which are extractable laterally for easy and quick replacement.

11. Apparatus according to any one of the Claims 8 to 10, where the means for melting and evaporating the surfacing materials are crucibles or high frequency inductors or electronic guns.

12. Apparatus for the surfacing of metallic and /or insulating materials on tape supports on reels according to any one of the Claims 8 to 11, characterized by the fact that it provides means controlling the deposition of the material and the uniformity of the deposed material layer; one by the coating module surveying the average ohmic resistance of the metallized surface of the reel; one placed in the rewinding module controlling the value of absorption of the intensity of the transmitted light or the value of the optical density, constituted by a projector (light or infrared) and a receiver by each evaporating mean, which provides beside the reading of the thickness of the deposit also the index of a good operation of each evaporating mean and then of the uniformity of the thickness of deposition.

13. Apparatus for the surfacing of metallic and/or insulating materials on tape supports on reels according to any one of the Claims 8 to 12, characterized by the fact that the means to have access to the chambers of the unwinding modules are coulisse doors and the loading system of the reel is with swinging arms.

14. Apparatus for the surfacing of metallic and/or insulating materials on tape supports on reels according to any one of the Claims 8 to 13, characterized by the fact that the means to have access to the chambers of the rewinding modules of the reels are coulisse doors and the unloading system of the reels is with swinging arms.

15. Apparatus for the surfacing of metallic and/or insulating materials on tape supports on reels according to any one of the Claims 8 to 14, characterized by the fact that the tunnels or sections of tunnel under different pressures are provided at the beginning and at the end with slots of variable width for the passing of the tape support in order to reduce the loss of vacuum pressure and avoid the passing of impurities.

16. Apparatus for the coating of tape supports on reels according to any one of the Claims 8 to 15, characterized by the fact that the vacuum pump systems of the modules are provided with cryogenic groups in order to increase the global efficency of the vacuum system.

17. Coated products obtained by the process according to any one of the Claims 1 to 7 and/or by the aooaratus according to any one of the Claims 8 to 16, like metallized plastic films, decorative and wall papers, fabrics with surfacing materials, labels, prints and so on, in particular respectively for use as dielectrics, for wrapping and packaging, for furniture and dressing, for labelling, publishing, typography and prinring.

Fig. 1

Fig. 2

Fig. 3

Fig. 4

Fig. 5

MOD I   MOD II   MOD III

I→II   II→III

Fig. 6

European
Patent Office

EUROPEAN SEARCH
REPORT

Application Number

EP 90 81 0548

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 728 406   (BANERJEE et al.)<br>* Figure 4; column 7, line 65 - column 8, line 2; column 8, lines 29-31; column 12, lines 49-58; column 13, lines 15-19,49-60 *<br>– – – | 1-4,6-9, 11,17 | C 23 C 14/54<br>C 23 C 14/56 |
| X | GB-A-766 459   (HERAEUS)<br>* Figure 2; claim 1 *<br>– – – | 1-4,6-8, 15 | |
| A | US-A-4 932 983   (NAGATOMI et al.)<br>* Claim 1 *<br>– – – | 5 | |
| A | US-A-2 975 753   (HAYES)<br>* Figure; column 3, lines 42-45,58-69 *<br>– – – | 10,11 | |
| A | EP-A-0 324 351   (SUMITOMO BAKELITE CO.)<br>* Claim 1 *<br>– – – – – | 12 | |

TECHNICAL FIELDS
SEARCHED (Int. Cl.5)

C 23 C

The present search report has been drawn up for all claims

| Place of search | Date of completion of search | Examiner |
|---|---|---|
| The Hague | 14 March 91 | PATTERSON A.M. |